# EUROPÄISCHE PATENTSCHRIFT

(11) **EP 0 850 489 B1**
(45) Veröffentlichungstag und Bekanntmachung des Hinweises auf die Patenterteilung: **03.01.2007**
(21) Anmeldenummer: 96934387.0
(22) Anmeldetag: 28.08.1996
(51) Int. Cl.: H01L 21/48, H01L 21/60, H05K 3/34

(54) **LOTDEPOTTRÄGER**
SOLDER DEPOSIT SUPPORT
SUPPORT DE DEPOT DE METAL D'APPORT DE BRASAGE

(30) Priorität: 08.09.1995 DE 19533169
(43) Veröffentlichungstag der Anmeldung: 01.07.1998
(73) Patentinhaber: Fraunhofer-Gesellschaft zur Förderung der angewandten Forschung e.V., 80686 München (DE)
(72) Erfinder: WOLF, Jürgen, D-13351 Berlin (DE); CHMIEL, Gerhard, D-48249 Dülmen (DE)
(74) Vertreter: Böck, Bernhard
(86) Internationale Anmeldenummer: PCT/DE1996/001592
(87) Internationale Veröffentlichungsnummer: WO 1997/009739

(56) Entgegenhaltungen:
- US-A- 4 832 255
- US-A- 5 217 597
- PATENT ABSTRACTS OF JAPAN vol. 18, no. 573 (E-1624), 2.November 1994 & JP,A,06 216135 (TOSHIBA CORP), 5.August 1994,
- IBM TECHNICAL DISCLOSURE BULLETIN, Bd. 36, Nr. 3, März 1993, NEW YORK US, Seiten 103-104, XP000354716 "Hydrogen overvoltage suppression in solder decal plating"
- IBM TECHNICAL DISCLOSURE BULLETIN, Bd. 36, Nr. 4, April 1993, NEW YORK US, Seiten 223-224, XP000364495 "Enhanced solder bump retention on solder decals"
- Lexicon <<<<werkstofftechnik; VOI-Verlag, Düsseldorf 1993; ISBN 3-18-401373-1, Seiten 76 und 83

## Beschreibung

Die vorliegende Erfindung betrifft einen Lotdepotträger zur selektiven Belotung von Anschlußflächen eines Substrats, der auf einer elektrisch leitfähigen, benetzungsunfähigen oder benetzunqshemmenden Beschichtung eine die Beschichtung im Bereich von Maskenöffnungen freigebende Obertragungsmaske aus einem elektrisch isolierenden, nicht-lötfähigen Material aufweist, wobei die Maskenöffnungen zur Aufnahme von galvanisch auf der Beschichtung abgeschiedenen Lotdepots dienen.

Aus der US-PS 5,217,597 sowie dem "IBM Technical Disclosure Bulletin" (Band 36, Nr. 3, März 1993, New York, Seiten 103-104, XP000354716 'Hydrogen overvoltage suppression in solder decal plating') sind

Verfahren zur selektiven Belotung von Anschlußflächen eines Substrats bekannt, bei denen zur Übertragung von Lotdepots auf die Anschlußflächen des Substrats Lotdepotträger verwendet werden, die zur Aufnahme und Übertragung der Lotdepots eine Übertragungsmaske mit Maskenöffnungen aufweisen. Zur galvanischen Abscheidung der Lotdepots in den Maskenöffnungen sind diese auf einer elektrisch leitfähigen Beschichtung angeordnet. Nach Abscheidung der Lotdepots in den Maskenöffnungen erfolgt die Übertragung der Lotdepots auf zu belotende Anschlußflächen eines Substrats, indem der Lotdepotträger so oberhalb des Substrats angeordnet wird, daß sich die Lotdepots in einer Überdeckungslage mit den zu belotenden Anschlußflächen befinden. Die eigentliche Übergabe der Lotdepots auf die unmittelbar darunter angeordneten Anschlußflächen erfolgt über einen sogenannten "Lotreflow", bei dem die Lotdepots in den Maskenöffnungen der Übertragungsmaske über die Schmelztemperatur des Lotes hinaus erwärmt werden und dabei die zu belotende Anschlußfläche benetzen. Eine Ablösung der schmelzflüssigen Lotdepots von der Beschichtung am Grunde der Maskenöffnungen wird bei dem bekannten Lotdepotträger dadurch ermöglicht, daß die Beschichtung aus einem Material besteht, das einerseits elektrisch leitfähig, andererseits aber auch nicht-lötfähig, also nicht benetzungsfähig, ist.

Für die Beschichtung des Lotdepotträgers wird in der US-PS 5,217,597 ein nicht-benetzungsfähiges Material angegeben, das auch unter der Bezeichnung ITO-Beschichtung bekannt ist und eine Indium/Zinn-Oxid-Legierung aufweist. Bei Versuchen mit dem bekannten Lotdepotträger hat sich gezeigt, daß die bekannte Beschichtung, bei der sowohl die Funktion einer galvanischen Trägerschicht als auch die Funktion einer nicht-benetzungsfähigen Kontaktschicht für die Lotdepots in den Maskenöffnungen von ein und demselben Schichtmaterial erfüllt wird, zu Nachteilen bei der Durchführung des bekannten Verfahrens führen. Insbesondere hat sich herausgestellt, daß aufgrund des relativ hohen elektrischen Schichtwiderstands der bekannten ITO-Beschichtung eine galvanische Abscheidung von Lotdepots auf dem Lotdepotträger bei größeren Lotdepotträgern, wie sie beispielsweise bei der Prozessierung großflächig verteilter Strukturen, etwa Halbleiterwafer, benötigt werden, aufgrund der hohen auftretenden Spannungsabfälle nicht prozessierbar sind.

Darüber hinaus sind bei dem aus der US-PS 5,217,597 bekannten Lotdepotträger die Maskenöffnungen der Übertragungsmaske so bemessen, daß die Lotdepots bei der galvanischen Abscheidung nur zu einem Teil innerhalb der Maskenöffnungen aufgenommen werden können, während ein anderer Teil der Lotdepots sich nach außerhalb der Maskenöffnungen und deren Ränder überdeckend erstreckt, mit der Folge, daß der stromdurchflossene Querschnitt der Lotdepots sich während des galvanischen Abscheidungsvorgangs im äußeren Teil der Lotdepots ändert. Falls diese Änderung des stromdurchflossenen Querschnitts nicht durch eine geeignete, aufwendige Prozeßsteuerung kompensiert wird, ist eine ungleichmäßige galvanische Lotabscheidung und eine entsprechend unkontrollierte Gefügezusammensetzung in den Lotdepots die Folge, was insbesondere der Ausbildung eutektischer Lotbumps oder allgemein der exakten Lotzusammensetzung entgegensteht.

Im IBM Technical Disclosure Bulletin wird für die Beschichtung eines aus Stahl bestehenden Lotdepotträgers als nicht benetzungsfähiges Material Titan angegeben. Bei diesem Aufbau dient der Lotdepotträger als elektrischer Leiter und weist einen relativ hohen elektrischen Widerstand auf.

Der vorliegenden Erfindung liegt die Aufgabe zugrunde, einen Lotdepotträger vorzuschlagen, der auch zur selektiven Belotung großflächigerer Substrate verwendbar ist.

Diese Aufgabe wird durch einen Lotdepotträger mit den Merkmalen des Anspruchs 1 gelöst.

Bei dem erfindungsgemäßen Lotdepotträger weist die auf eine Trägerstruktur aufgebrachte Beschichtung zwei übereinander angeordnete Metallschichten mit unterschiedlichen Materialien auf, derart, daß die den Maskenöffnungen zugewandte Kontaktschicht benetzungsunfähig ist oder benetzungshemmend wirkt, und die den Maskenöffnungen abgewandt angeordnete Schicht bei der galvanischen Abscheidung als Stromführungsschicht wirkt.

Durch die erfindungsgemäße Separierung der Beschichtung in zwei in ihren Funktionen voneinander unabhängige Metallschichten können die Schichtmaterialien jeweils in optimaler Weise an die betreffende Funktion angepaßt ausgewählt werden, so daß "Kompromißlösungen", wie es bei der bekannten ITO-Beschichtung der Fall ist, zur Bereitstellung einer Materialzusammensetzung, die beide genannten Funktionen erfüllen soll, nicht mehr notwendig sind. Zur Realisierung der Stromführungsfunktion, die für die galvanische Abscheidung des Lotmaterials auf der Beschichtung notwendig ist, kann nun ohne Berücksichtigung der Benetzungsfähigkeit eine Materialauswahl getroffen werden, die die Stromführungsfunktion optimal erfüllt. Dementsprechend kann auch zur Erzielung der gewünschten Benetzungsunfähigkeit eine Schicht ausgewählt werden, die dieses Erfordernis optimal erfüllt und deren elektrische Eigenschaften eine nur untergeordnete Rolle spielen. Die Schichten können als legierte und unlegierte Schichten ausgebildet sein.

Die Aufteilung der Beschichtung in zwei voneinander unabhängige, funktionsoptimierte Schichten ermöglicht eine Materialauswahl für die bei der galvanischen Abscheidung stromführende Schicht mit besonders hoher elektrischer Leitfähigkeit und entsprechend geringem elektrischen Widerstand, so daß im Gegensatz zu der bekannten ITO-Beschichtung bei der erfindungsgemäßen Beschichtung nur relativ geringe Spannungsabfälle in der Beschichtung bei der galvanischen Abscheidung zu verzeichnen sind, und daher die Lotdepotträger auch in Größen herstellbar sind, wie sie zur selektiven Belotung ganzer Wafer erforderlich sind.

Bei einer bevorzugten Ausführungsform des Lotdepotträgers ist die stromführende Schicht aus Kupfer oder einer Kupferlegierung und die benetzungsunfähige oder benetzungshemmende Schicht aus Titan oder einer Titanlegierung gebildet. Neben der besonders guten Leitfähigkeit einer derart ausgebildeten Stromführungsschicht und der besonders gut ausgebildeten Benetzungsunfähigkeit einer derart ausgebildeten Kontaktschicht, zeichnet sich die Beschichtung bei einer derartigen Materialauswahl durch eine besonders gute Temperaturstabilität aus. Gute Ergebnisse wurden auch bei Verwendung von Chrom oder einer Chrom-Legierung, insbesondere einer Chrom/Wolfram-Legierung, für die Kontaktschicht erzielt.

Als besonders vorteilhaft erweist es sich auch, wenn die Übertragungsmaske mit Maskenöffnungen versehen ist, die derart bemessen sind, daß die maximale Querschnittsfläche der Lotdepots in Abscheiderichtung durch den Öffnungsquerschnitt der Maskenöffnungen bestimmt ist. Hierdurch wird sichergestellt, daß die stromdurchflossene Querschnittsfläche der Lotdepots bei deren kontinuierlichen Abscheidung in den Maskenöffnungen während der gesamten galvanischen Abscheidung konstant ist. Damit bleibt auch ohne aufwendige Prozeßsteuerung die Stromdichte während des Abscheidevorgangs unverändert, so daß eine gleichmäßige galvanische Lotabscheidung mit einem entsprechendem Gefüge der Lotdepots die Folge ist. Da in derartigen Maskenöffnungen abgeschiedene Lotdepots keinen über die Ränder der Maskenöffnungen seitlich hinausgehenden Überstand aufweisen, sind auch kleinere Abstände zwischen den Lotdepots und somit höhere Auflösungen bei der Lotdepotanordnung möglich.

Bei einer weiteren Ausführungsform des Lotdepotträgers ist die Trägerstruktur verformbar ausgebildet, um eine bessere Anpassung der Lotdepotträger-Topographie durch ein Anschmiegen an das zu benetzende Substrat zu ermöglichen. Hierdurch wird die Benetzung der zu belotenden Anschlußflächenmetallisierungen des Substrats und damit die Übertragung der Lotdepots auf die Anschlußflächen des Substrats erleichtert. Als besonders vorteilhaft erweist sich in diesem Zusammenhang eine flexible Ausbildung der Trägerstruktur, da aufgrund der elastischen Rückstellkräfte der Trägerstruktur für jede nachfolgende, erneute Verwendung des Lotdepotträgers wieder dieselbe Ausgangsform des Lotdepotträgers bzw. der Trägerstruktur zur Verfügung steht. Hierdurch ist auch bei verformbaren Trägerstrukturen Reproduzierbarkeit in der Ausführung des Übertragungsverfahrens gegeben.

Eine besonders vorteilhafte Art der Herstellung des Lotdepotträgers ist gegeben, wenn die Trägerstruktur als Laminat aus mehreren Laminatlagen oder auch als eine einzelne Laminatlage ausgebildet ist. Wenn darüber hinaus zumindest die stromführende, also die der Trägerstruktur benachbarte Schicht als Laminatlage ausgebildet ist, ist es möglich, zumindest einen Teil der Beschichtung zusammen mit der Trägerstruktur als Laminat herzustellen. Ergänzend hierzu kann auch die auf der stromführenden Schicht angeordnete benetzungsunfähige oder benetzungshemmende Schicht als Laminatlage ausgebildet und im Laminierverfahren mit der stromführenden Schicht verbunden sein.

Um die Haftung der auf der benetzungsunfähigen oder benetzungshemmenden Schicht aufgebrachten Lotdepots zu vergrößern, und somit die Handhabung des Lotdepotträgers während der Lotdepotübertragung zu verbessern, kann die Oberfläche der Beschichtung eine Rauhtiefe aufweisen, die größer als 1 µm ist. Hierdurch wird für ein sicheres Haften der Lotdepots an der Beschichtung gesorgt, ohne daß die beim Lotdepot-Reflow einsetzende Entnetzung zur Übertragung der Lotdepots auf die Anschlußflächen des Substrats negativ beeinflußt würde. Besonders gute Ergebnisse wurden dabei mit einer Rauhtiefe im Bereich von 3 bis 5 µm erzielt.

Zur Erzeugung der Rauhtiefe in der Oberfläche der benetzungsunfähigen oder benetzungshemmenden Schicht erweist es sich als besonders vorteilhaft, wenn die Oberfläche der stromführenden Schicht mit der für die Oberfläche der darüber angeordneten benetzungsunfähigen oder benetzungshemmenden Schicht gewünschten Rauhtiefe versehen ist, wobei sich diese Rauhtiefe dann infolge der in gleichmäßiger Dicke aufgebrachten benetzungsunfähigen oder benetzungshemmenden Schicht in deren Oberfläche abbildet.

Nachfolgend wird eine Ausführungsform des Lotdepotträgers anhand der Zeichnungen näher erläuter: Es zeigen:
- **Fig. 1**: einen Lotdepotträger vor der galvanischen Abscheidung von Lotdepots;
- **Fig. 2**: den Lotdepotträger nach der galvanischen Abscheidung der Lotdepots;
- **Fig. 3**: den Lotdepotträger in einer Überdeckungslage mit einem zu belotenden Substrat;
- **Fig. 4**: den Lotdepotträger bei der Übertragung der Lotdepots auf Anschlußflächen des Substrats;
- **Fig. 5**: das Substrat mit auf den Anschlußflächen aufgebrachten Lotbumps.

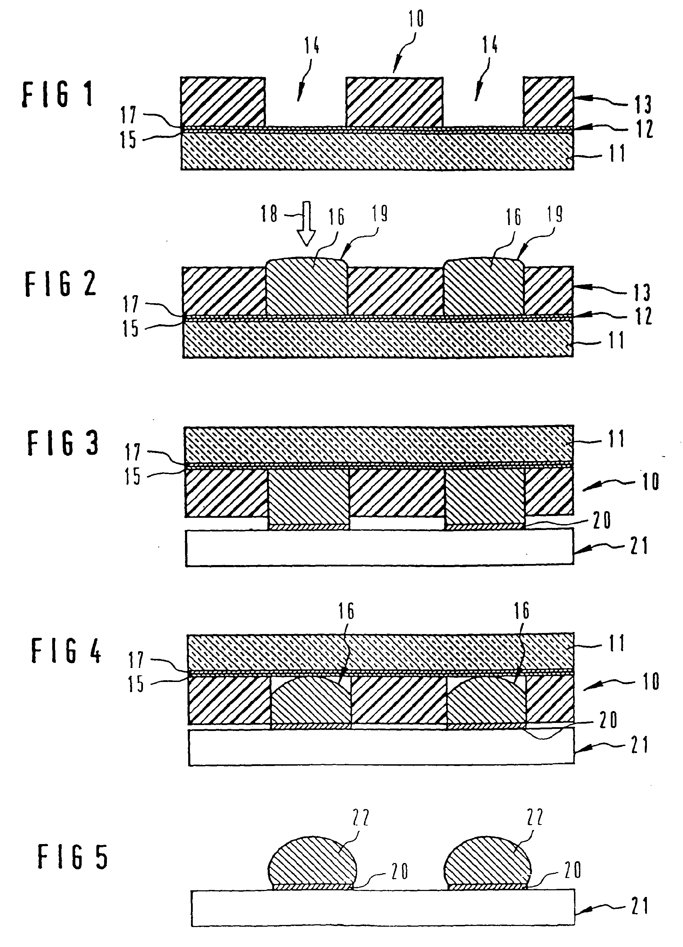

**Fig. 1** zeigt einen Lotdepotträger 10 mit einer hier aus einem Silizium-Wafer bzw. aus einem Waferteilstück gebildeten Trägerstruktur 11, auf deren Oberfläche eine Beschichtung 12 angeordnet ist. Für die Trägerstruktur sind Halbleiter-Materialien allgemein und auch andere Materialien, wie beispielsweise Leiterplatten-Materialien oder keramische Materialien, verwendbar. Auf der Beschichtung 12 befindet sich eine Übertragungsmaske 13 mit darin vorgesehenen Maskenöffnungen 14. Die Übertragungsmaske 13 besteht bei diesem Ausführungsbeispiel aus einer photolithografisch strukturierten Polymermaske, beispielsweise aus Polyimid, BCB oder auch Epoxydharz. Neben den vorgenannten Beispielen für eine permanente Maske, die eine häufige Wiederverwendbarkeit des Lotdepotträgers ermöglicht, sind zur Herstellung der Übertragungsmaske auch andere Materialien und Verfahren verwendbar. So können auch photolithografische oder laseroptisch strukturierte Lackmasken als ein Beispiel für temporäre Masken eingesetzt werden.

Die Beschichtung 12 weist zwei übereinanderliegend angeordnete Schichten, nämlich eine bei einem galvanischen Abscheidungsvorgang stromführende Stromführungsschicht 15 und eine darauf angeordnete, mit galvanisch abgeschiedenen Lotdepots 16 (**Fig. 2**) in Kontakt stehende Kontaktschicht 17. Abweichend von dem in **Fig. 1** dargestellten Ausführungsbeispiel, in dem die Schichten 15 und 17 ganzflächig einander überdeckend ausgebildet sind, kann die Stromführungschicht 15 auch aus in einer Ebene angeordneten, zusammenhängenden Teilschichten und die Kontaktschicht 17 aus darauf im Bereich der Maskenöffnungen ausgebildeten Teilschichten bestehen. Bei dem hier dargestellten Ausführungsbeispiel besteht die Stromführungsschicht 15 aus einer etwa 1 µm starken Kupfer-Schicht und die Kontaktschicht 17 aus einer etwa 200 nm starken Schicht aus einer Titan/Wolfram-Legierung. Um einen Verzug der Trägerstruktur 11 infolge des Aufbringens der Beschichtung 12 zu verhindern, hat es sich bei Versuchen als besonders vorteilhaft herausgestellt, die Beschichtung beidseitig auf die Trägerstruktur 11 aufzubringen. Darüber hinaus hat sich auch ein Aufbau der Beschichtung 12 aus hier nicht sämtlich dargestellten, insgesamt drei Schichten als vorteilhaft herausgestellt, wobei außer der Stromführungsschicht 15 und der Kontaktschicht 17 noch eine weitere Grundierungsschicht, beispielsweise aus einer Titan/Wolfram-Legierung mit einer Stärke von etwa 200 nm, zwischen der Oberfläche der Trägerstruktur 11 und der Stromführungsschicht 15 vorgesehen werden kann. Die Grundierungsschicht dient sowohl als Haftschicht als auch als Diffusionssperrschicht. Die beispielhaft genannten Schichtdicken können beliebig variiert werden, solange die genannten Funktionen der verschiedenen Schichten gewahrt bleiben.

**Fig. 2** zeigt den Lotdepotträger 10 nach erfolgter galvanischer Abscheidung der Lotdepots 16 auf der Beschichtung 12 im Bereich der Maskenöffnungen 14. Das Lotmaterial der Lotdepots 16 besteht hier aus einer Blei/Zinn-Legierung (63% Sn/37%Pb) und wird im wesentlichen vollständig von den Maskenöffnungen 14 aufgenommen. Grundsätzlich sind alle Lotmaterialien verwendbar, aus denen Lotdepots im galvanischen Abscheideverfahren herstellbar sind. **Fig. 2** zeigt deutlich, daß die maximale Querschnittsfläche Fₘₐₓ der Lotdepots 16 übereinstimmt mit dem Öffnungsquerschnitt M der Maskenöffnungen 14 und in Abscheiderichtung (Pfeil 18) konstant ist. Ein Überstand 19 der Lotdepots 16 über die Übertragungsmaske 13 hinaus, ist lediglich durch einen sich bei der galvanischen Abscheidung ergebenden Meniskus gebildet. Aufgrund der weitestgehend konstanten Querschnittsfläche der Lotdepots 16 ergibt sich bei der Abscheidung der Lotdepots eine weitestgehend konstante, homogene Gefügezusammensetzung.

**Fig. 3** zeigt den Lotdepotträger 10 in einer mit den erstarrt in den Maskenöffnungen 14 aufgenommenen Lotdepots 16 nach unten gerichteten Stellung, wobei sich die Lotdepots 16 in Vorbereitung deren Übertragung auf Anschlußmetallisierungen 20 eines Substrats 21 in einer Überdeckungslage mit den Anschlußmetallisierungen 20 befinden.

Bei dem Substrat 21 kann es sich um einen Chip mit beliebiger Verteilung von Anschlußmetallisierungen 20 oder auch um ein als Chipträger dienendes Substrat, insbesondere mit einer flächenverteilten Anordnung von Anschlußmetallisierungen 20 handeln, wie sie unter dem Begriff "Ball Grid Array" (BGA) bekannt ist.

Die Anschlußmetallisierungen 20 bestehen im vorliegenden Fall aus einer Nickel/Gold-Legierung, die beispielsweise stromlos auf standardmäßigen Anschlußflächen aus einer Aluminium/Silizium-Legierung (99%Al/1% Si) gebildet sind.

**Fig. 4** zeigt, wie durch einen sogenannten "Lotdepot-Reflow", bei dem das in Form der Lotdepots 16 abgeschiedene Lotmaterial wieder rückerschmolzen wird, eine Übertragung der Lotdepots auf die Anschlußmetallisierungen 20 des Substrats 21 erfolgt. Damit diese Übertragung möglichst vollständig erfolgt, ist die benetzufigshemmende bzw. benetzungsunfähige, also die einer Benetzung bzw. einem Haftenbleiben der Lotdepots 16 an der Kontaktschicht 17 entgegenwirkende Ausbildung der Kontaktschicht 17 besonders wesentlich.

**Fig. 5** zeigt schließlich die nach Abheben des Lotdepotträgers 10 vom Substrat 21 auf den Anschlußmetallisierungen 20 des Substrats ausgebildeten Lotbumps 22.

Um zu verhindern, daß es beim Aufschmelzen der Lotdepots 16 und der damit verbundenen Entnetzung oder Trennung der Lotdepots 16 von der Kontaktschicht 17 zu einer Oxydation des Lotmaterials kommt, kann das Aufschmelzen sowie auch die Übertragung der Lotdepots in einer reduzierenden oder inerten Atmosphäre erfolgen. Weiterhin kann zur Unterstützung der Übertragung des Lotdepots auf das Substrat ein Flußmittel verwendet werden.

Zur Verbesserung der Haftung der Lotdepots an der Kontaktschicht 17 kann die Oberfläche der stromführenden Schicht 15 aufgerauht sein und eine Rauhtiefe im Bereich von 3 bis 5 µm aufweisen. Das Aufrauhen der stromführenden Schicht 15, die in der Regel eine wesentlich größere Dicke als die Kontaktschicht 17 aufweist, kann mittels bekannter mechanischer Verfahren, z. B. durch Läppen oder Schleifen erfolgen.

In einer erprobten Ausführungsform des Lotdepotträgers wurde als Trägermaterial das Leiterplatten-Material FR 4/5 mit einer auflaminierten, etwa 20 µm starken Kupfer-Folie als stromführende Schicht verwendet. Die Oberfläche der stromführenden Schicht wurde mittels Läppen zur Erzielung einer Rauhtiefe von 3 bis 5 µm aufgerauht. Die benetzungsunfähige oder benetzungshemmende Schicht wurde als Titan/Wolfram-Schicht mittels Sputtern aufgebracht, wodurch sich die Topographie der stromführenden, aufgerauhten Schicht in der Kontaktschicht abbildete. Die Kontaktschicht wies somit die gewünschte Rauhtiefe zwischen 3 und 5 µm auf. Bei der Verwendung des derart ausgebildeten Lotdepotträgers zur Übertragung von Lotdepots stellte sich heraus, daß die Haftung der galvanisch abgeschiedenen Lotdepots auf der Kontaktschicht verbessert war, ohne daß die Entnetzung der Lotdepots beim anschließenden Lotdepot-Reflow zur Übertragung der Lotdepots negativ beeinflußt wurde.

Bei den vorgenannten Versuchen hat sich auch gezeigt, daß unabhängig von der Zusammensetzung und Art etwaiger darunter liegender Materialschichten eine mit gezielt erhöhter Rauhtiefe versehene Oberfläche der Kontaktschicht die Haftung zwischen der Kontaktschicht und darauf angeordneter benetzender Lotdepots grundsätzlich verbessert ohne negative Beeinflussung einer nachfolgenden Entnetzung. Diese vorteilhafte Wirkung der mit aufgerauhter Oberfläche versehenen Kontaktschicht ist unabhängig von der Art und Weise, in der die Lotdepots auf die Kontaktschicht aufgebracht werden. Die Wirkung tritt beispielsweise auch bei physikalischen Auftragsverfahren, wie Aufdampfen, Lotdepotauftrag, Festkörperlotauftrag, auf.

## Patentansprüche

1. Lotdepotträger zur selektiven Belotung von Anschlußflächen eines Substrats, der auf einer elektrisch leitfähigen, benetzungsunfähigen oder benetzungshemmenden Beschichtung eine die Beschichtung im Bereich von Maskenöffnungen freigebende Übertragungsmaske aus einem elektrisch isolierenden, nicht lötfähigen Material aufweist,
wobei die Maskenöffnungen zur Aufnahme von galvanisch auf der Beschichtung abgeschiedenen Lotdepots dienen,
**dadurch gekennzeichnet,**
**daß** die auf eine Trägerstruktur (11) aufgebrachte Beschichtung (12) zwei übereinander angeordnete Metallschichten (15, 17) mit unterschiedlichen Materialien aufweist, derart, daß die den Maskenöffnungen (14) zugewandte Schicht (17) benetzungsunfähig ist oder benetzungshemmend wirkt, und die den Maskenöffnungen (14) abgewandt angeordnete Schicht (15) bei der galvanischen Abscheidung als stromführende Schicht wirkt.

2. Lotdepotträger nach Anspruch 1,
**dadurch gekennzeichnet,**
**daß** die stromführende Schicht (15) aus Kupfer oder einer Kupferlegierung und die benetzungsunfähige oder benetzungshemmende Schicht (17) aus Titan oder einer Titanlegierung gebildet ist.

3. Lotdepotträger nach Anspruch 1,
**dadurch gekennzeichnet,**
**daß** die stromführende Schicht (15) aus Kupfer oder einer Kupferlegierung und die benetzungsunfähige oder benetzungshemmende Schicht (17) aus Chrom oder einer Chromlegierung gebildet ist.

4. Lotdepotträger nach einem oder mehreren der vorangehenden Ansprüche,
**dadurch gekennzeichnet,**
**daß** die Übertragungsmaske (13) mit Maskenöffnungen (14) versehen ist, die derart bemessen sind, daß die maximale Querschnittsfläche Fₘₐₓ der Lotdepots (16) in Abscheiderichtung (18) durch den Öffnungsquerschnitt M der Maskenöffnungen (14) bestimmt ist.

5. Lotdepotträger nach einem oder mehreren der vorangehenden Ansprüche,
**dadurch gekennzeichnet,**
**daß** die Trägerstruktur (11) verformbar, vorzugsweise flexibel, ausgebildet ist.

6. Lotdepotträger nach einem oder mehreren der vorangehenden Ansprüche,
**dadurch gekennzeichnet,**
**daß** die Trägerstruktur (11) als Laminat aus mehreren Laminatlagen oder als einzelne Laminatlage ausgebildet ist.

7. Lotdepotträger nach Anspruch 6,
**dadurch gekennzeichnet,**
**daß** zumindest die stromführende Schicht (15) der Beschichtung (12) als Laminatlage ausgebildet und mit der Trägerstruktur (11) verbunden ist.

8. Lotdepotträger nach einem oder mehreren der vorangehenden Ansprüche,
**dadurch gekennzeichnet,**
**daß** die Oberfläche der Beschichtung eine Rauhtiefe aufweist, die größer als ein Mikrometer ist.

9. Lotdepotträger nach Anspruch 8,
**dadurch gekennzeichnet,**
**daß** die Oberfläche der stromführenden Schicht (15) eine Rauhtiefe aufweist, die größer als ein Mikrometer ist, und die benetzungsunfähige oder benetzungshemmende Schicht (17) mit gleichmäßiger Dicke auf die Schicht (15) aufgebracht ist.

## Claims

1. Solder deposit carrier for the selective soldering of terminal areas of a substrate, comprising on an electrically conductive, non-wettable or wetting-inhibiting coating a transfer mask of an electrically isolating, non-solderable material which exposes the coating in the area of mask openings, in which the mask openings serve to accommodate solder deposits electroplated onto the coating,
**characterised in that**
the coating (12) applied to a carrier structure (11) comprises two superimposed metal layers (15, 17) of different materials, such that the layer (17) facing towards the mask openings (14) is non-wettable or has a wetting-inhibiting effect, and the layer (15) arranged facing away from the mask openings (14) acts as a current-carrying layer during the electroplating.

2. Solder deposit carrier according to claim 1,
**characterised in that**
the current-carrying layer (15) is formed of copper or a copper alloy and the non-wettable or wetting-inhibiting layer (17) of titanium or a titanium alloy.

3. Solder deposit carrier according to claim 1,
**characterised in that**
the current-carrying layer (15) is formed of copper or a copper alloy and the non-wettable or wetting-inhibiting layer (17) of chromium or a chromium alloy.

4. Solder deposit carrier according to one or more of the preceding claims,
**characterised in that**
the transfer mask (13) is provided with mask openings (14) which are so proportioned that the maximum cross-sectional area Fₘₐₓ of the solder deposits (16) in the plating direction (18) is determined by the opening cross-section M of the mask openings (14).

5. Solder deposit carrier according to one or more of the preceding claims,
**characterised in that**
the carrier structure (11) is constructed so as to be deformable, preferably flexible.

6. Solder deposit carrier according to one or more of the preceding claims,
**characterised in that**
the carrier structure (11) is constructed as a laminate of several laminate plies or as a single laminate ply.

7. Solder deposit carrier according to claim 6,
**characterised in that**
at least the current-carrying layer (15) of the coating (12) is constructed as a laminate ply and is connected to the carrier structure (11).

8. Solder deposit carrier according to one or more of the preceding claims,
**characterised in that**
the surface of the coating exhibits a roughness height which is more than a micrometer.

9. Solder deposit carrier according to claim 8,
**characterised in that**
the surface of the current-carrying layer (15) exhibits a roughness height which is more than a micrometer, and the non-wettable or wetting-inhibiting layer (17) is applied in uniform thickness to the layer (15).

## Revendications

1. Support de dépôt de brasure pour le brasage sélectif de surfaces de raccordement d'un substrat, le support de dépôt de brasure présentant, sur un revêtement conducteur électrique, inapte à la réticulation ou inhibant la réticulation, un masque de transfert libérant le revêtement au niveau d'ouvertures du masque, en matériau isolant au niveau électrique et inapte au brasage, dans lequel les ouvertures du masque servent à recevoir des dépôts de brasure déposés par galvanisation sur le revêtement,
**caractérisé en ce que**
le revêtement (12) appliqué sur une structure support (11) présente deux couches métalliques superposées (15, 17) contenant diverses matières de manière à ce que la couche (17) tournée vers les ouvertures du masque (14) soit inapte à la réticulation ou ait un effet inhibiteur de réticulation et que la couche (15) disposée détournée des ouvertures du masque (14) fasse office de couche conductrice de courant lors du dépôt par galvanisation.

2. Support de dépôt de brasure selon la revendication 1,
**caractérisé en ce que**
la couche conductrice de courant (15) est en cuivre ou en alliage de cuivre et la couche inapte à la réticulation ou inhibant la réticulation (17) est composée de titane ou d'un alliage de titane.

3. Support de dépôt de brasure selon la revendication 1,
**caractérisé en ce que**
la couche conductrice de courant (15) est en cuivre ou en alliage de cuivre et la couche inapte à la réticulation ou inhibant la réticulation (17) est composée de chrome ou d'un alliage de chrome.

4. Support de dépôt de brasure selon une ou plusieurs des revendications précédentes,
**caractérisé en ce que**
le masque de transfert (13) est pourvu d'ouvertures de masque (14) qui sont dimensionnées de manière à ce que la surface maximale de section transversale Fₘₐₓ des dépôts de brasure (16) soit déterminée dans le sens de dépôt (18) par la section transversale d'ouverture M des ouvertures de masque (14).

5. Support de dépôt de brasure selon une ou plusieurs des revendications précédentes,
**caractérisé en ce que**
la structure support (11) est déformable, de préférence souple.

6. Support de dépôt de brasure selon une ou plusieurs des revendications précédentes,
**caractérisé en ce que**
la structure support (11) est réalisée sous forme de plusieurs couches de laminé ou sous forme d'une seule couche de laminé.

7. Support de dépôt de brasure selon la revendication 6,
**caractérisé en ce qu'**
au moins la couche conductrice de courant (15) du revêtement (12) est réalisée sous forme d'une couche de laminé et est reliée à la structure support (11).

8. Support de dépôt de brasure selon une ou plusieurs des revendications précédentes,
**caractérisé en ce que**
la surface du revêtement présente une rugosité supérieure à un micromètre.

9. Support de dépôt de brasure selon la revendication 8,
**caractérisé en ce que**
la surface de la couche conductrice de courant (15) présente une rugosité qui est supérieure à un micromètre et que la couche inapte à la réticulation ou inhibant la réticulation (17) est appliquée en une épaisseur régulière sur la couche (15).
